# EUROPEAN PATENT APPLICATION

(11) **EP 2 026 384 A2**
(43) Date of publication of application: **18.02.2009**
(21) Application number: 08152406.8
(22) Date of filing: 06.03.2008
(51) Int. Cl.: H01L 29/792, H01L 29/51, H01L 27/115, G11C 16/04

(54) **Charge trapping memory cell with high speed erase**

(30) Priority: 13.08.2007 US 955391 P; 27.08.2007 US 845276
(71) Applicant: MACRONIX INTERNATIONAL CO., LTD., Hsinchu (TW)
(72) Inventor: Lue, Hang-Ting, Hsinchu (TW); Lai, Sheng-Chih, 406, Taichung City (TW)
(74) Representative: Barth, Stephan Manuel

(57) **Abstract**

A band gap engineered, charge trapping memory cell includes a charge trapping element (16) that is separated from a metal or metal compound gate (18), such as a platinum gate, by a blocking layer (17) of material having a high dielectric constant, such as aluminum oxide, and separated from the semiconductor body (10) including the channel by an engineered tunneling dielectric (13,14,15). Fast program and erase speeds with memory window as great as 7 V are achieved.

## Description

### CROSS REFERENCE TO RELATED APPLICATION

The benefit of U.S. Provisional Patent Application No. 60/955,391, filed on 13 August 2007, is hereby claimed.

### BACKGROUND OF THE INVENTION

### Field of the Invention

The present invention relates to flash memory technology, and more particularly to scalable charge trapping memory technology adaptable for high speed erase and program operations.

### Description of Related Art

Flash memory is a class of non-volatile integrated circuit memory technology. Traditional flash memory employs floating gate memory cells. As the density increases in memory devices, and the floating gate memory cells get closer and closer together, interference between the charge stored in adjacent floating gates becomes a problem. This is limiting the ability to increase the density of flash memory based on floating gate memory cells. Another type of memory cell used for flash memory can be referred to as a charge trapping memory cell, which uses a dielectric charge trapping layer in place of the floating gate. Charge trapping memory cells use dielectric charge trapping material that does not cause cell-to-cell interference like that encountered with floating gate technology, and is expected to be applied for higher density flash memory.

The typical charge trapping memory cell consists of a field effect transistor FET structure having a source and drain separated by a channel, and a gate separated from the channel by a stack of dielectric material including a tunnel dielectric layer, the charge storage layer, and a blocking dielectric layer. According to the early conventional designs referred to as SONOS devices, the source, drain and channel are formed in a silicon substrate (S), the tunnel dielectric layer is formed of silicon oxide (O), the charge storage layer is formed of silicon nitride (N), the blocking dielectric layer is formed a silicon oxide(O), and the gate comprises polysilicon (S). The SONOS device is programmed by electron tunneling using one of a number of well-known biasing technologies, and erased by hole tunneling or electron de-trapping. In order to achieve practical operational speeds for the erase operation, the tunneling dielectric layer must be quite thin (less than 30 Å). However at that thickness, the endurance and charge retention characteristics of the memory cell are poor relative to traditional floating gate technology. Also, with relatively thick tunneling dielectric layers, the electric field required for the erase operation also cause electron injection from the gate through the blocking dielectric layer. This electron injection causes an erase saturation condition in which the charge level in the charge trapping device converges on an equilibrium level. See, U.S. Patent No. 7,075,828, entitled "Operation Scheme with Charge Balancing Erase for Charge Trapping Non-Volatile Memory", invented by Lue et al. However, if the erase saturation level is too high, the cell cannot be erased at all, or the threshold margin between the programmed and erased states becomes too small for many applications.

On one hand, technology has been investigated to improve the ability of the blocking dielectric layer to reduce electron injection from the gate for the high electric fields needed for erase. See, U.S. Patent No. 6,912,163, entitled "Memory Device Having High Work Function Gate and Method of Erasing Same," Invented by Zheng et al., issued 28 June 2005; and U.S. Patent No. 7,164,603, entitled "Operation Scheme with High Work Function Gate and Charge Balancing for Charge Trapping Non-Volatile Memory", invented by Shih et al., Shin et al., "A Highly Reliable SONOS-type NAND Flash Memory Cell with Al2O3 or Top Oxide," IEDM, 2003 (MANOS); and Shin et al., "A Novel NAND-type MONOS Memory using 63 nm Process Technology for a Multi-Gigabit Flash EEPROMs", IEEE 2005. In the just-cited references, the second Shin et al. article describes a SONOS type memory cell in which the gate is implemented using tantalum nitride and the blocking dielectric layer is implemented using aluminum oxide (referred to as the TANOS device), which maintains a relatively thick tunneling dielectric layer at about 4 nm. The relatively high work function of tantalum nitride inhibits electron injection through the gate, and the high dielectric constant of aluminum oxide reduces the magnitude of the electric field through the blocking dielectric layer relative to the electric field for the tunneling dielectric layer. Shin et al. report a trade-off between the breakdown voltage of the memory cell, the thickness of the aluminum oxide layer and the thickness of the tunneling dielectric layer. With a 4 nm thick silicon dioxide tunneling dielectric in a TANOS device, relatively high erase voltages are proposed in order to achieve erase speeds. An increase in erase speeds would require increasing the voltages applied or decreasing the thickness of the tunneling dielectric layer. Increasing the voltage applied for erase is limited by the breakdown voltage. Decreasing the thickness of the tunneling dielectric layer is limited by issues of charge retention and erase saturation, as mentioned above.

On the other hand, technology has been investigated to improve the performance of the tunneling dielectric layer for erase at lower electric fields. See, U.S. Patent Application Publication No. US 2006/0198189 A1, "Non-Volatile Memory Cells, Memory Arrays Including the Same and Method of Operating Cells and Arrays," Invented by Lue et al., publication date September 7, 2006 (describing a "BE-SONOS device"); Lue et al., "BE-SONOS: A Bandgap Engineered SONOS with Excellent Performance and Reliability", IEEE, December 2005; Wang et al., "Reliability and Processing Effects of the Bandgap Engineered SONOS (BE-SONOS) Flash Memory", IEEE, May 2007. See also, U.S. Patent Application Publication No. 2006/0261401 A1, entitled "Novel Low Power Non-Volatile Memory and Gate Stack", by Bhattacharyya, published 23 November 2006.

BE-SONOS technology has been proven to provide excellent performance, overcoming many of the erase speed, endurance and charge retention issues of prior art SONOS type memory. However, the problem of the erase saturation continues to limit operational parameters of the device. Furthermore, as the device sizes shrink, it is expected that erase saturation problems will intensify. Accordingly, is desirable to provide a new memory technology which overcomes the erase saturation issues of prior art technologies, and that can be applied in very small memory devices.

### SUMMARY OF THE INVENTION

A band gap engineered, charge trapping memory cell is described including a charge trapping element that is separated from a metal or metal compound gate, such as a platinum gate, by a blocking layer of material having a high dielectric constant κ, such as aluminum oxide, and separated from the semiconductor body including the channel by an engineered tunneling dielectric. The engineered tunneling dielectric includes a combination of materials having negligible charge trapping efficiency, and band offset characteristics. The band offset characteristics include a relatively large hole tunneling barrier height in a thin region at the interface with the semiconductor body, and an increase in valence band energy level so that the hole tunneling barrier height at a first offset less than 2nm for example from the channel surface, from the interface is relatively low. The band offset characteristics also include an increase in conduction band energy by providing a thin layer of relatively high electron tunneling barrier height at a second offset more than 2nm from the channel surface, separating the material with a relatively lower hole tunneling barrier height from the charge trapping layer. Very fast erase speed is obtained using the memory cell described herein, without erase saturation, providing a memory window and operating speed much greater than possible in prior art technologies.

The valence band energy level at the first offset is such that an electric field sufficient to induce hole tunneling through the thin region between the interface with the semiconductor body and the offset, is also sufficient to raise the valence band energy level after the offset to a level that effectively eliminates the hole tunneling barrier in the engineered tunneling dielectric after the offset. This structure enables electric field assisted hole tunneling at high speeds while effectively preventing charge leakage through the engineered tunneling dielectric in the absence of electric fields or in the presence of smaller electric fields induced for the purpose of other operations, such as reading data from the cell or programming adjacent cells.

In a representative device, the engineered tunneling dielectric layer consists of an ultrathin silicon oxide layer O1 (e.g. <=15 A), an ultrathin silicon nitride layer N1 (e.g. < =30 A) and an ultrathin silicon oxide layer 02 (e.g. <=30 A), which results in an increase in the valence band energy level of about 2.6 eV at an offset 15A or less, from the interface with the semiconductor body. The 02 layer separates the N1 layer from the charge trapping layer, at a second offset (e.g. about 35 to 45 A from the interface), by a region of lower valence band energy level (higher hole tunneling barrier). The electric field sufficient to induce hole tunneling between the interface and the first offset also raises the valence band energy level after the second offset to a level that effectively eliminates the hole tunneling barrier, because the second offset is at a greater distance from the interface. Therefore, the 02 layer does not significantly interfere with the electric field assisted hole tunneling, while improving the ability of the engineered tunneling dielectric to block leakage during low fields.

The blocking dielectric structure in a representative memory device, consists of aluminum oxide which has a dielectric constant (K about 7 or 8) about twice that of silicon dioxide. Therefore, the electric field intensity in the blocking dielectric structure is relatively low compared to that in the tunneling dielectric layer.

The present technology combines techniques for reducing the electric field in the blocking dielectric layer relative to the tunneling dielectric layer, with techniques for reducing the magnitude of the electric field required for erase to achieve high speed erase operations without saturation, enabling a large memory window compared to prior devices. Also, charge retention and endurance characteristics of the memory cell are very good.

A charge trapping memory is described based on this technology that includes an array of memory cells. The memory cells include a semiconductor body having a channel with a channel surface and source and drain terminals adjacent the channel. The tunneling dielectric layer lies on the channel surface, and is characterized by negligible charge trapping efficiency and band offset technology. A charge trapping dielectric layer lies on the tunneling dielectric layer. A blocking dielectric layer lies on the charge trapping layer. The blocking dielectric layer comprises a material having a dielectric constant κ greater than 3.9, and preferably comprises aluminum oxide or other material having a dielectric constant K of about 7 or higher. The gate lies on the blocking dielectric layer. The gate comprises a metal or other conductive material on the blocking dielectric layer. Embodiments of the technology can employ a material for the gate such as platinum, which has a relatively high work function, i.e. greater than 4.5 eV.

Circuitry is coupled to the array of memory cells to apply bias voltages to selected memory cells for read, program and erase operations.

In the technology described herein, the bias voltages across the gate and substrate of the device are 20 V or less, well below breakdown voltages for erase operations, and demonstrate threshold shifts supporting a memory window of as much as 7 V or more. In addition, for the device described herein, the bias voltages applied during erase operations induce an electric field less than 14 MV/cm across the dielectric tunneling layer, and accomplish a threshold shift of greater than 5 V in less than 10 ms, without erase saturation. Circuitry can be implemented in combination with the charge trapping memory cell described herein to accomplish a negative threshold shift of greater than 5 V in less than 1 ms without erase saturation. Erase speeds of less than 10 ms can be accomplished using bias voltages less than 15 V, enabling the implementation of very small scale devices that have relatively low breakdown voltages.

The bias voltages applied during program operations likewise are capable of very fast program operations by electron tunneling through the tunneling dielectric layer, accomplishing in some embodiments a positive threshold shift of greater than 5 V, and as much as 7 V, in less than 1 ms, and in other embodiments in less than 0.1 ms.

The memory cell described herein can provide flash technology with a relatively large memory window (greater than 7 V) with excellent data retention. Also, the memory cell described herein should be scalable to 50 nm manufacturing nodes, to 40 nm nodes and below.

Other aspects and advantages of the present invention can be seen on review of the drawings, the detailed description in the claims which follow.

### BRIEF DESCRIPTION OF THE DRAWINGS

Fig. 1 is a simplified diagram of an embodiment of a memory cell according to the present invention.

Figure 2 is a band diagram for a tunneling dielectric layer including band offset technology at a low electric fields.

Figure 3 is a band diagram for a tunneling dielectric layer including band offset technology at high electric fields.

Figure 4 illustrates the electric field intensities during an erase operation for an embodiment of a memory cell according to the present invention.

Figure 5 is a schematic diagram of a NAND-type memory array employing memory cells according to the present invention.

Figure 6 is a simplified cross-sectional view of memory cells according to the present invention in a NAND configuration, taken perpendicular to word lines.

Figure 7 is a simplified cross-sectional view of memory cells according to the present invention in a NAND configuration, taken through a word line.

Figure 8 is a block diagram of an integrated circuit memory employing memory cells and bias circuitry according to embodiments of the present invention.

Figure 9 is a graph of flat band voltage versus erase bias time showing erase curves for various erase bias voltages for an embodiment of a memory cell according to the present invention.

Figure 10 is a graph of flat band voltage versus erase bias time comparing erase curves of other charge trapping cell structures with an erase curve of a memory cell according to the present invention.

Figure 11 is a plot of current density versus electric field in the tunneling dielectric layer using transient analysis for various bias voltages, comparing other charge trapping cell structures with a memory cell according to the present invention.

Figure 12 is a plot of the erase curves of a memory cell according to the present invention with various band offset distances in the tunneling dielectric layer.

Figure 13 is a plot showing program characteristics with various program biases for an embodiment of a memory cell according to the present invention.

Figure 14 is a graph showing erase curves for four representative devices having different gate materials.

Figure 15 is a graph showing transient electric fields in the tunnel layers and blocking layer for three devices described herein.

### DETAILED DESCRIPTION

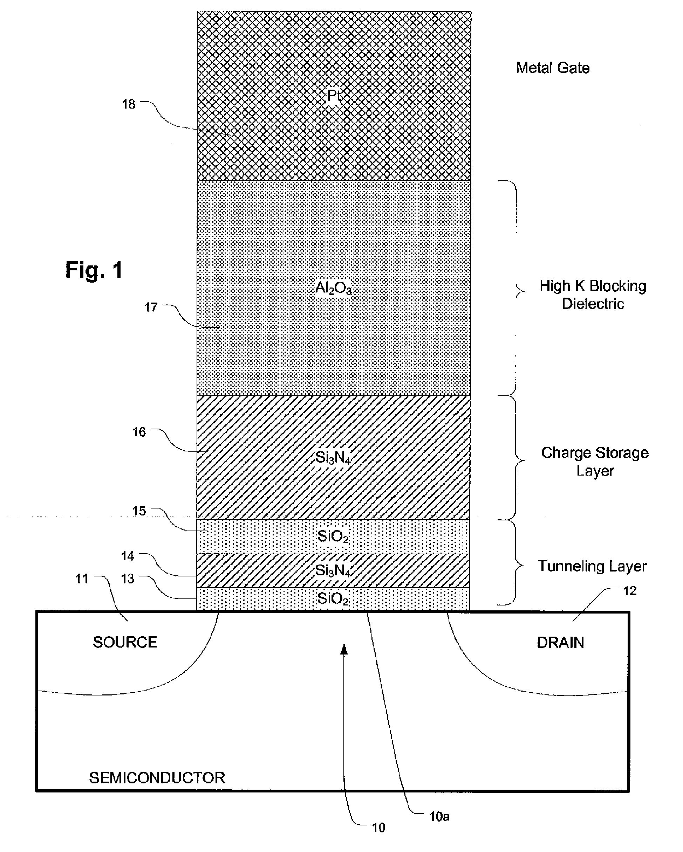

A detailed description of embodiments of the present invention is provided with reference to the Figs 1-15.

Figure 1 is a simplified diagram of a charge trapping memory cell employing a high κ blocking dielectric layer and a band gap engineered dielectric tunneling layer. The memory cell includes a channel 10 in a semiconductor body, and a source 11 and a drain 12 adjacent channel.

A gate 18 in this embodiment comprises platinum having a work function of about 8 electron volts eV. Preferred embodiments employ metals or metal compounds for the gate 18, such as platinum, tantalum nitride, aluminum or other metal or metal compound gate materials. It is preferable to use materials having work functions higher than 4.5 eV. A variety of high work function materials suitable for use as a gate terminal are described in U.S. Patent No. 6,912,163, referred to above. Such materials are typically deposited using sputtering and physical vapor deposition technologies, and can be patterned using reactive ion etching.

Embodiments of the memory cell can also employ other metals, such as aluminum, having a work function of about 4.3 eV, as explained in more detail below.

In the embodiment illustrated in Figure 1, the dielectric tunneling layer comprises a composite of materials, including a first layer 13, referred to as a hole tunneling layer, of silicon dioxide on the surface 10a of the channel 10 formed for example using in-situ steam generation ISSG with optional nitridation by either a post deposition NO anneal or by addition of NO to the ambient during deposition. The thickness of the first layer 13 of silicon dioxide is within the range of about 10 Å to 20 Å, and preferably 15 Å or less.

A layer 14, referred to as a band offset layer, of silicon nitride lies on the first layer 13 of silicon oxide formed for example using low-pressure chemical vapor deposition LPCVD, using for example dichlorosilane DCS and NH₃ precursors at 680 degrees C. In alternative processes, the band offset layer comprises silicon oxynitride, made using a similar process with an N₂O precursor. The thickness of the layer 14 of silicon nitride is within the range of about 10 Å to 30 Å, and preferably 25 Å or less.

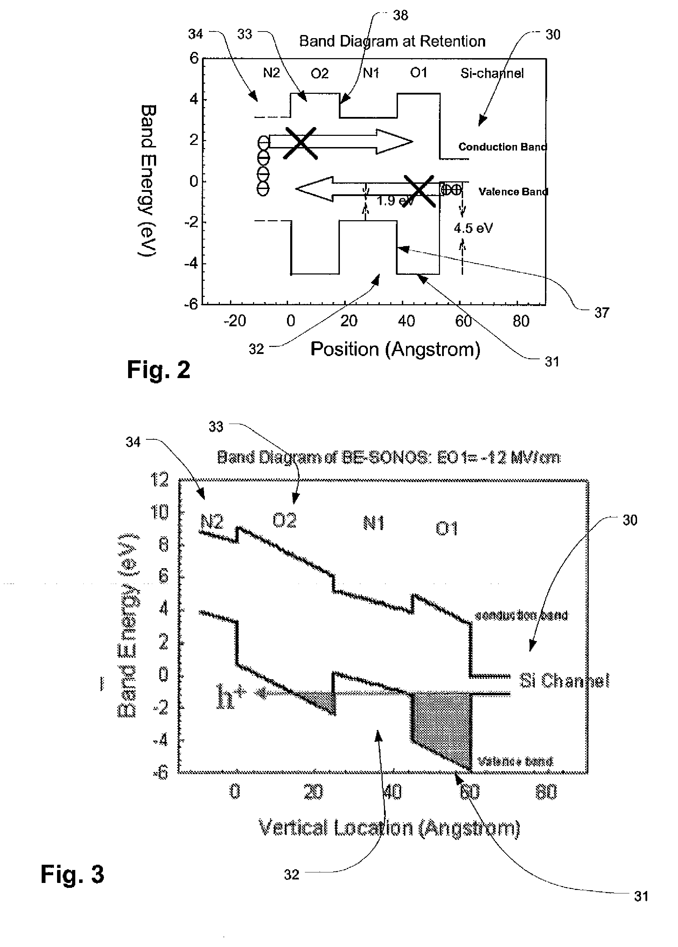

A second layer 15 of silicon dioxide, referred to as an isolation layer, lies on the layer 14 of silicon nitride formed for example using LPCVD high temperature oxide HTO deposition. The thickness of the second layer 15 of silicon dioxide is less than 30 Å, and preferably 25 Å or less. The structure of the dielectric tunneling layer is described in more detail below with reference to Figures 2 and 3.

A charge trapping layer 16 in this embodiment comprises silicon nitride having a thickness within the range of about 50 Å to 100 Å, including for example about 70 Å in this embodiment formed for example using LPCVD. Other charge trapping materials and structures may be employed, including for example silicon oxynitride (SiₓO_{y}N_{z}), silicon-rich nitride, silicon-rich oxide, trapping layers including embedded nano-particles and so on.

The blocking dielectric layer 17 in this embodiment comprises aluminum oxide (Al₂O₃), having a dielectric constant K of about 8 or more. The layer 17 of aluminum oxide is greater than the thickness of the layer 17 of silicon nitride, including for example at least twice as thick. In illustrated example, the layer 17 of aluminum oxide is within the range of about 50 Å to 150 Å, and for example about 150 Å in the embodiments described herein, formed by atomic vapor deposition AVD with a post deposition rapid thermal anneal at 900° C for about 60 seconds to strengthen the film. In other embodiments, high κ dielectric material such as hafnium oxide (HfO₂) having a κ of about 10, titanium oxide (TiO₂) having a κ of about 60, praseodymium oxide (Pr₂O₃) having a κ of about 30 may be used. Oxides of zirconium Zr and lanthanum La may used as well. In some embodiments, oxides of more than one metal may be used, including for example, oxides of hafnium and aluminum, oxides or zirconium and aluminum, and oxides of hafnium, aluminum and zirconium.

In a representative embodiment, the first layer 13 is 13 Å of silicon dioxide; the band offset layer 14 is 20 Å of silicon nitride; the isolation layer 15 is 25 Å of silicon dioxide; the charge trapping layer 16 is 70 Å of silicon nitride; and the blocking dielectric layer 17 is 150 Å of aluminum oxide.

Figure 2 is a diagram of the energy levels of the conduction and valence bands of the dielectric tunneling structure the including the stack of layers 13-15 of Figure 1 under a low electric field, showing a "U-shaped" conduction band and an "inverted U-shaped" valence band. From the right side, the band gap for the semiconductor body is shown in region 30, the valence and conduction bands for the hole tunneling layer are shown in region 31, the band gap for the offset layer is shown in region 32, the valence and conduction bands for the isolation layer are shown in region 33 and the valence and conduction bands for the charge trapping layer are shown in region 34. Electrons, represented by the circles with the negative sign, trapped within the charge trapping region 34 are unable to tunnel to the conduction band in the channel, because the conduction band of the tunneling dielectric layer in all three regions 31, 32, 33 remains high relative to the energy level of the trap. The likelihood of electron tunneling correlates with the area under the "U-shaped" conduction band in the tunneling dielectric layer and above a horizontal line at the energy level of the trap to the channel. Thus, electron tunneling is very unlikely at low field conditions. Likewise, holes in the valence band of the channel in region 30 are blocked by the full thickness of regions 31, 32 and 33 from tunneling to the charge trapping layer 34, and the high hole tunneling barrier height at the channel interface. The likelihood of hole tunneling correlates with the area over the "inverted U-shaped" valence band in the tunneling dielectric layer and below a horizontal line at the energy level of the channel to the charge trapping layer. Thus, hole tunneling is very unlikely at low field conditions. For the representative embodiment, in which the hole tunneling layer comprises silicon dioxide, a hole tunneling barrier height of about 4.5 eV prevents hole tunneling. The valence band in the silicon nitride remains 1.9 eV below that of the valence band in the channel. Therefore, the valence band in all three layers 31, 32, 33 the tunneling dielectric structure remain significantly below the valence band in the channel 30. The tunneling layer described herein therefore is characterized by band offset characteristics, include a relatively large hole tunneling barrier height in a thin region (layer 31) at the interface with the semiconductor body, and an increase 37 in valence band energy level at a first offset less than 2nm from the channel surface. The band offset characteristics also include a decrease 38 in valence band energy level at a second offset from the channel by providing a thin layer 33 of relatively high tunneling barrier height material, resulting in the inverted U-shaped valence band shape. Likewise, the conduction band has a U-shape caused by the same selection of materials.

Figure 3 shows the band diagram for the dielectric tunneling structure under conditions of an electric field of about - 12 MV/cm in the tunneling layer 31, for the purposes of inducing hole tunneling (in Figure 3, the O1 layer is about 15 Å thick). Under the electric field the valence band slopes upward from the channel surface. Therefore, at an offset distance from the channel surface the valence band in the tunneling dielectric structure increases in band energy level substantially, and in the illustration rises above the band energy in the valence band in the channel region. Therefore, the hole tunneling probability is increased substantially as the area (shaded in Figure 3) between the level of the valence band in the channel and above sloped, inverted U-shaped valence band in the tunneling stack is reduced. The band offset effectively eliminates the blocking function of the offset layer in region 32 and isolation layer in region 33 from the tunneling dielectric during high electric field allowing a large hole tunneling current under relatively small electric fields (e.g. E < 14 MV/cm).

The isolation layer 33 isolates the offset layer 32 from a charge trapping layer 34. This increases the effective blocking capability during low electric field for both electrons and holes, improving charge retention.

The offset layer 32 in this embodiment must be thin enough that it has negligible charge trapping efficiency. Also, the offset layer is a dielectric, and not conductive. Thus, for an embodiment employing silicon nitride, the offset layer should be less than 30 Å thick, and more preferably about 25 Å or less.

The hole tunneling layer 31, for an embodiment employing silicon dioxide, should be less than 20 Å thick, and more preferably less than 15 Å thick. For example, in a preferred embodiment, the hole tunneling layer 31 is silicon dioxide about 13 Å thick, and exposed to a nitridation process as mentioned above resulting in an ultrathin silicon oxynitride.

The tunneling dielectric layer can be implemented in embodiments of the present invention using a composite of silicon oxide, silicon oxynitride and silicon nitride without precise transitions between the layers, so long as the composite results in the required inverted U-shape valence band, having a change in valence band energy level at the offset distance from the channel surface needed for efficient hole tunneling. Also, other combinations of materials could be used to provide band offset technology.

The description of the dielectric tunneling layer focuses on "hole tunneling" rather than electron tunneling because the technology has solved the problems associated with the need to rely on hole tunneling in SONOS type memory. For example, a tunnel dielectric consisting of silicon dioxide which is thin enough to support hole tunneling at practical speeds, will be too thin to block leakage by electron tunneling. The effects of the engineering however, also improve performance of electron tunneling. So, both programming by electron tunneling and erasing by hole tunneling are substantially improved using band gap engineering.

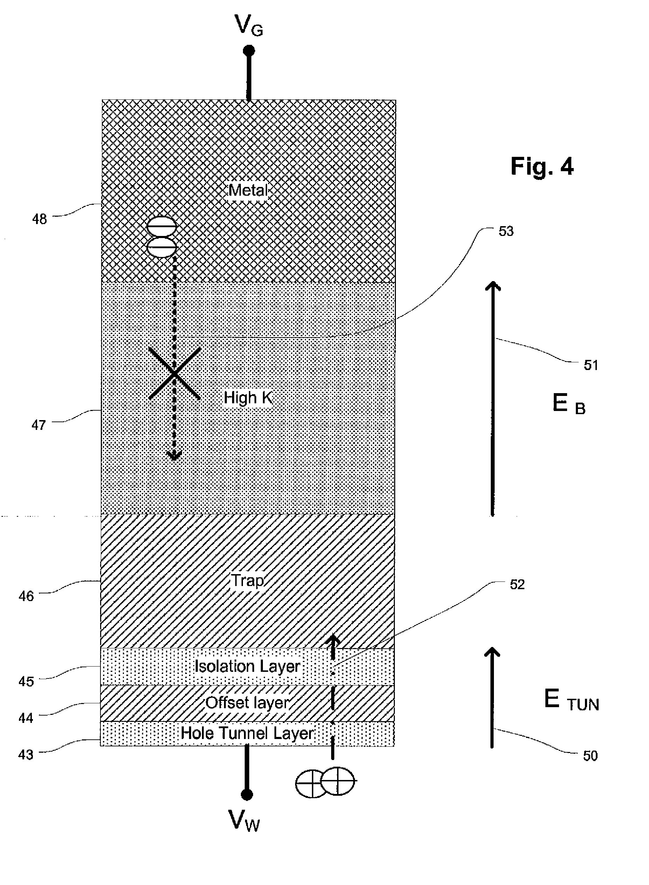

Figure 4 is a schematic illustration of the gate stack for a charge trapping memory cell like that Figure 1, showing electric field dynamics during an erase process. The gate stack includes a hole tunneling layer 43, a band offset layer 44, and an isolation layer 45 which in combination act as the dielectric tunneling layer for the device. A charge trapping layer 46 is shown on the tunneling dielectric layer. A blocking dielectric layer 47 consisting of a high κ insulator such as aluminum oxide separates the charge trapping layer 46 from the metal gate 48. During an erase process, the electric field is induced by bias voltages V_{G} and V_{W} applied at the gate and channel of the memory cell, and results in an electric field E_{TUN} 50 through the dielectric tunneling layer 43, 44, 45 and an electric field E_{B} 51 through the blocking layer 47. The magnitude of the electric field E_{TUN} 50 through the dielectric tunneling layer is sufficient to induce hole tunneling current 52 into the trapping layer 46. The magnitude of the electric field E_{B} 51 through the blocking dielectric layer 47 is reduced relative to that through the silicon dioxide in the tunneling dielectric layer because of the high dielectric constant. Therefore, because of the electron affinity of the metal gate 46, the relatively lower electric field E_{B} 51 and the thickness of the blocking dielectric layer 47, electron tunneling current 53 is effectively blocked, allowing large memory windows without erase saturation effects.

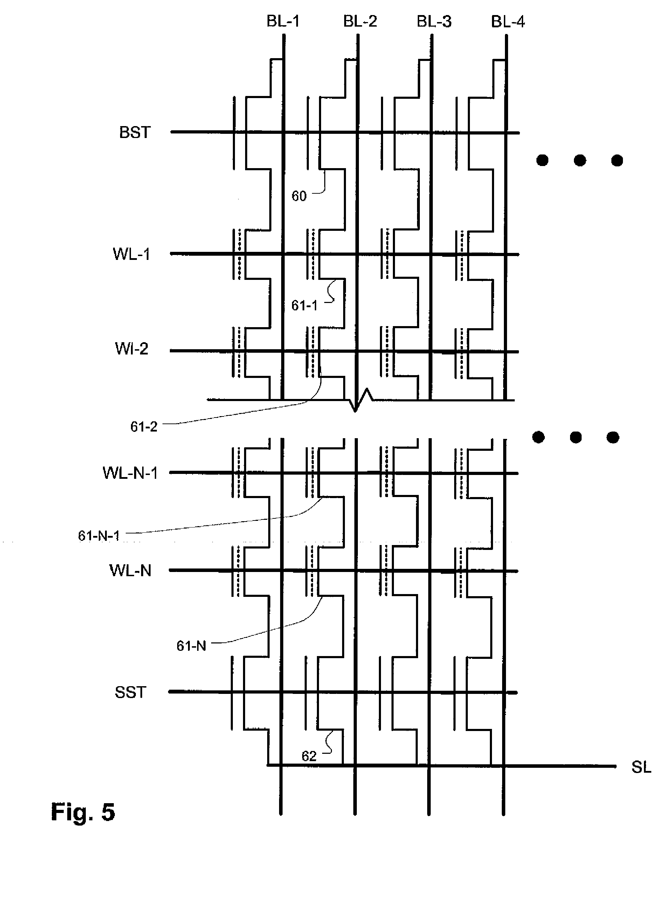

Memory cells implemented as described above can be arranged in a NAND-type array as shown in Figure 5. The array includes a plurality of bit lines BL-1, BL-2, BL-3, BL-4, ..., and a plurality of word lines WL-1, WL-2, ..., WL-N-1, WL-N. Groups of N memory cells are connected in series between a block select transistor coupled to a corresponding bit line and a source select transistor coupled to a source line. A block select word line BST is coupled to a row of block select transistors and a source select word line SST is coupled to a row of source line connect transistors. Thus, for example, for a representative bit line, BL-2, in the figure, a block select transistor 60 connects a series of memory cells 61-1 through 61-N to the bit line BL-2 in response to the signal BST on the block select word line. The last memory cell 61-N in the series is connected to source select transistor 62 which couples the series to the source line SL in response to the signal SST on a source select word line.

In the alternative, the memory cells can be arranged NOR-type or virtual ground-type arrays often applied in flash memory devices.

Programming may be accomplished in the NAND array by applying incremental stepped pulse programming ISPP or other processes for inducing Fowler Norheim tunneling. ISPP involves applying a stepped programming voltage, starting at a gate bias of for example about plus 17 V, and incrementing the voltage for each programming step by about 0.2 V. Each pulse can have a constant pulse width of about 10 µs for example. In variations of the technique, the pulse width and the increment applied for each succeeding pulse can be varied to meet the needs of the particular implementation. The memory cells of this type have demonstrated relatively linear programming characteristics, and very large memory windows compared to the prior art, making them particularly well-suited to storing multiple bits per cell with multilevel programming technologies. In alternative embodiments, the so-called voltage pulse self-boosting technique is applied for programming. Other biasing arrangements can be applied as well, selected for compatibility with array characteristics.

Other programming bias techniques can be applied. For NOR array structures, various biasing arrangements for inducing hot electron tunneling or FN tunneling may be applied as well as other techniques known in the art.

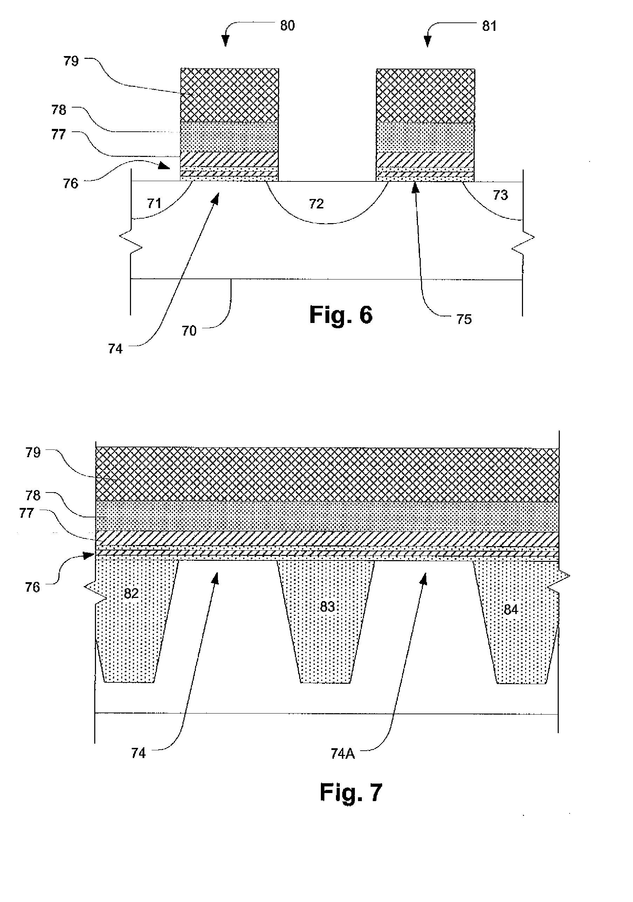

Figures 6 and 7 show cross-sectional views of a representative memory cell structure as described herein implemented in a NAND-type array, taken across the word lines and along the word line respectively. Figure 6 shows a semiconductor body 70 including channel regions 74, 75 and source/drain terminals 71, 72, 73 contacting the channel regions. The channel length between the source and drain terminals is preferably less than 50 nm, and in preferred embodiments 30 nm or less. The composite dielectric tunneling layer 76, the charge trapping layer 77, the blocking dielectric layer 78 and the metal gate word line layer 79 are arranged in stacks 80 and 81 over the channel regions 74 and 75 of respectively.

Figure 7 shows the structure of Figure 6 taken in cross section along a word line which includes the same stack with the same reference numerals as described with reference to Figure 6. Column of series connected cells are separated by shallow trench isolation STI structures 82, 83, 84. In the illustration, the surfaces of the channel 74, and of the adjacent channel 74A, are planar. Implementations of the device may include recessed (concave) channel surfaces in this cross-section, or extended (convex) channel surfaces, depending on the manufacturing techniques and the desired product. The tunneling dielectric layer 76 and the rest of the stack 77, 78, 79 overlie the channel surfaces, whether planar, concave or convex, in a conformal manner. The channel width between the STI structures 80, 82 is preferably less than 50 nm, and more preferably as small as the STI techniques allow.

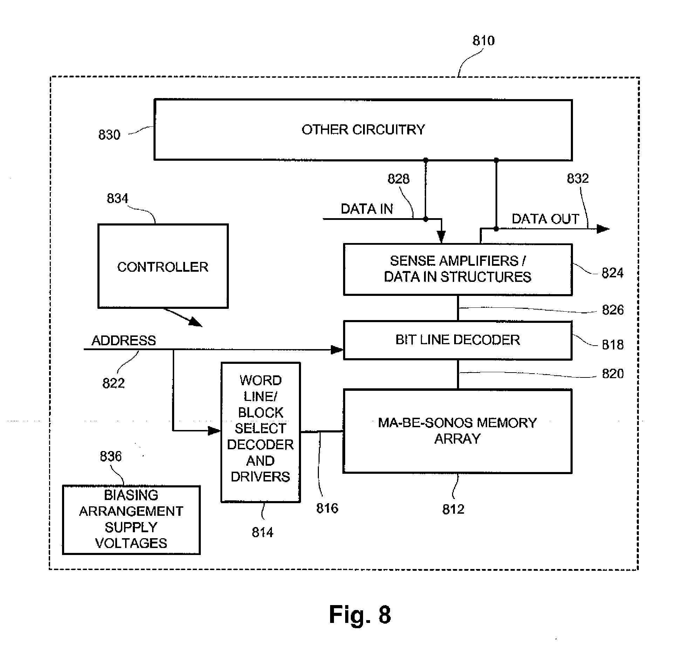

FIG. 8 is a simplified block diagram of an integrated circuit employing MA-BE-SONOS memory cells as described herein having a metal gate, an aluminum oxide or other high κ dielectric blocking layer, and a band gap engineered tunneling dielectric layer. The integrated circuit 810 includes a memory array 812 implemented using MA-BE-SONOS memory cells as described herein on a semiconductor substrate. A word line (or row) and block select decoder 814 is coupled to, and in electrical communication with, a plurality 816 of word lines and block select lines, and arranged along rows in the memory array 812. A bit line (column) decoder and drivers 818 are coupled to and in electrical communication with a plurality of bit lines 820 arranged along columns in the memory array 812 for reading data from, and writing data to, the memory cells in the memory array 812. Addresses are supplied on bus 822 to the word line decoder and drivers 814 and to the bit line decoder 818. Sense amplifiers and data-in structures in block 824, including current sources for the read, program and erase modes, are coupled to the bit line decoder 818 via data the bus 826. Data is supplied via the data-in line 828 from input/output ports on the integrated circuit 810 or from other data sources internal or external to the integrated circuit 810, to the data-in structures in block 824. In the illustrated embodiment, other circuitry 830 is included on the integrated circuit 810, such as a general purpose processor or special purpose application circuitry, or a combination of modules providing system-on-a-chip functionality supported by the memory cell array. Data is supplied via the data-out line 832 from the sense amplifiers in block 824 to input/output ports on the integrated circuit 810, or to other data destinations internal or external to the integrated circuit 810.

The array 812 can be a NAND array, an AND array or a NOR array, depending on the particular application. The very large memory window available supports storing multiple bits per cell, and thus multiple bit sense amplifiers can be included on the device.

A controller implemented in this example, using bias arrangement state machine 834, controls the application of bias arrangement supply voltages and current sources 836, such as read, program, erase, erase verify, program verify voltages or currents for the word lines and bit lines, and controls the word line/source line operation using an access control process. The controller 834 can be implemented using special purpose logic circuitry as known in the art. In alternative embodiments, the controller 834 comprises a general purpose processor, which may be implemented on the same integrated circuit, which executes a computer program to control the operations of the device. In yet other embodiments, a combination of special-purpose logic circuitry and a general-purpose processor may be utilized for implementation of the controller 834.

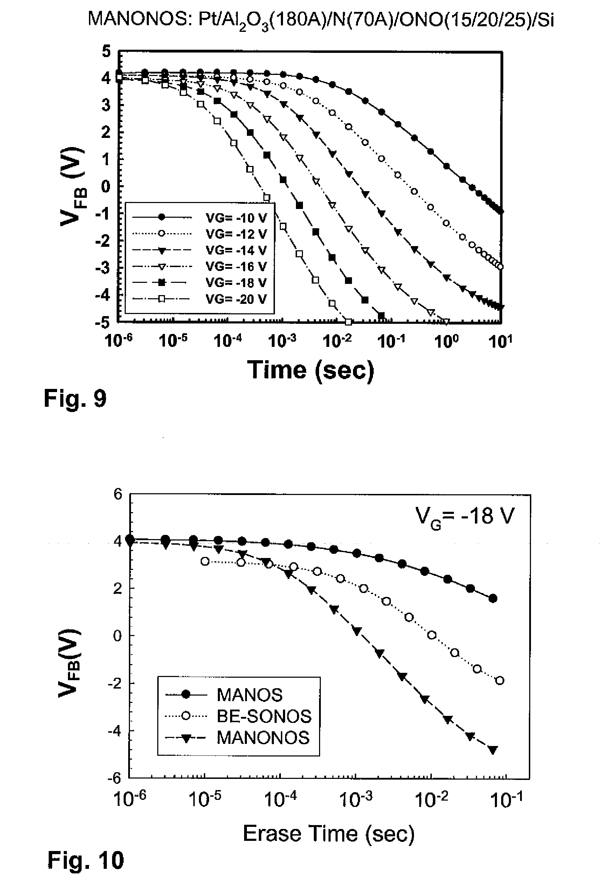

Figure 9 is a graph of flat band voltage versus erase bias time showing erase curves for various erase bias voltages for an embodiment of a memory cell (referred to as a MA BE-SONOS cell herein) in which the gate comprises platinum, the blocking dielectric layer comprises 180 Å of aluminum oxide, the charge trapping layer comprises 70 Å of silicon nitride, and the tunneling dielectric layer comprises 15 Å, 20 Å and 25 Å respectively of silicon dioxide, silicon nitride and silicon dioxide formed on a silicon substrate. The channel is grounded in these examples, so that the gate voltage VG represents the bias voltage across the stack. The plot shows the erase speed for VG ranging from minus 10 to minus 20 V in 2 V increments. Very high erase speeds are obtained using the structure. For bias voltages less than 20 V, hole tunneling current is sufficient to cause a reduction a threshold voltage for selected cell of more than 4 V less than 5 ms. For bias voltages less than 16 V, hold tunneling current sufficient to cause a reduction in threshold voltage and a selected so of more than 4 V less than 10 ms. Threshold shifts of as much as 7 V are readily achieved. Also, it can be seen, an erase time of less than 10 ms can be achieved for a gate voltage of about 15 V, showing that the technology is applicable to devices having relatively low breakdown voltages, such as very small devices, and nonetheless operable at relatively high speeds needed for NAND flash applications. These performance measurements demonstrate that this technology is scalable to devices having gate lengths on the order of 50 nm or lower, using maximum gate voltages on the order of 15 V.

Figure 10 is a graph of flat band voltage versus erase bias time comparing erase curves of a tested MANOS cell having a platinum gate, a 180 Å aluminum oxide blocking dielectric layer, a 70 Å silicon nitride trapping layer, and a 45 Å silicon dioxide tunneling layer; and BE-SONOS cell with a p+-polysilicon gate, a 90 Å silicon dioxide blocking dielectric layer, a 70 Å silicon nitride trapping layer, and an ONO tunneling dielectric layer having a 25 Å isolation layer, a 20 Å offset layer and a 15 Å hole tunneling layer; and a MA BE-SONOS cell sample as described above. The three samples have similar equivalent oxide thicknesses EOT of about 180 Å. Under the same bias voltage of negative 18 V, the MA BE-SONOS sample shows superior erase speed over the other devices, readily achieving a 4 V drop and threshold voltage in about 1 ms, as compared to about 10 ms for BE-SONOS and over 100 ms for the MANOS sample. The tested cells have more than an order of magnitude faster erase speed than the prior art MANOS and BE-SONOS technologies.

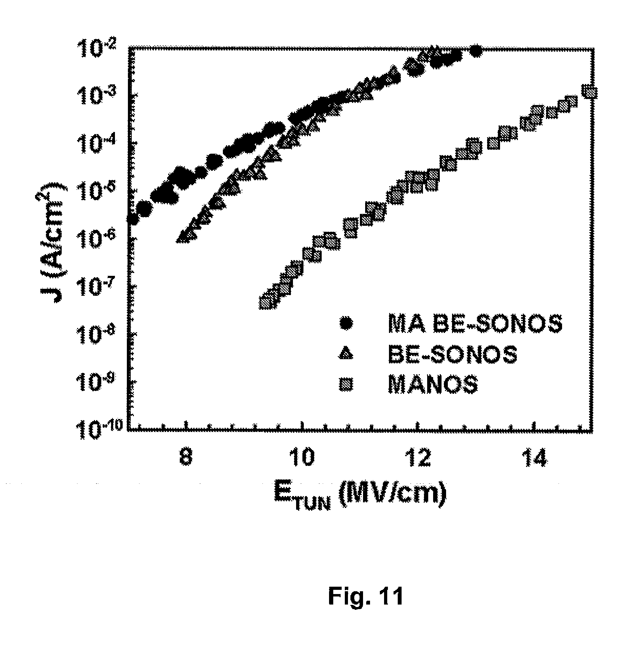

Figure 11 is a plot of current density J (A/cm²) versus electric field E_{TUN} (MV/cm) in the tunneling dielectric layer using transient analysis for various bias voltages, comparing the MANOS, BE-SONOS and MA BE-SONOS cell samples described above. As can be seen, for an electric field E_{TUN} less than 14 MV/cm the current density for hole tunneling for both the MA-BE-SONOS and the BE-SONOS samples are much high than that of the MANOS sample. For the MA BE-SONOS sample, no erase saturation is encountered, so that they can be continuously erased to a flat band voltage of less than -5 V. Practical devices can be operated readily with electric fields E_{TUN} smaller than 14 MV/cm for inducing hole tunneling current, including electric fields E_{TUN} as small as 10 or 11 MV/cm.

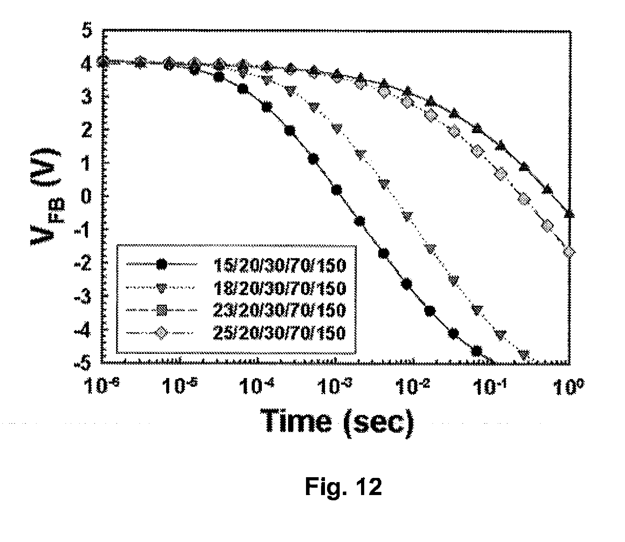

Figure 12 is a plot of the erase curves for the MA-BE-SONOS sample with various band offset distances as determined by the thickness of the hole tunneling layer in the tunneling dielectric layer. As can be seen, the erase speed dramatically improves the for a hole tunneling layer comprising silicon dioxide less than about 20 Å thick, and continues to improve below 18 Å. Embodiments of BE-SONOS show continued erase speed improvements with reduction of the thickness of the hole tunneling layer comprising silicon dioxide to about 15 Å or less.

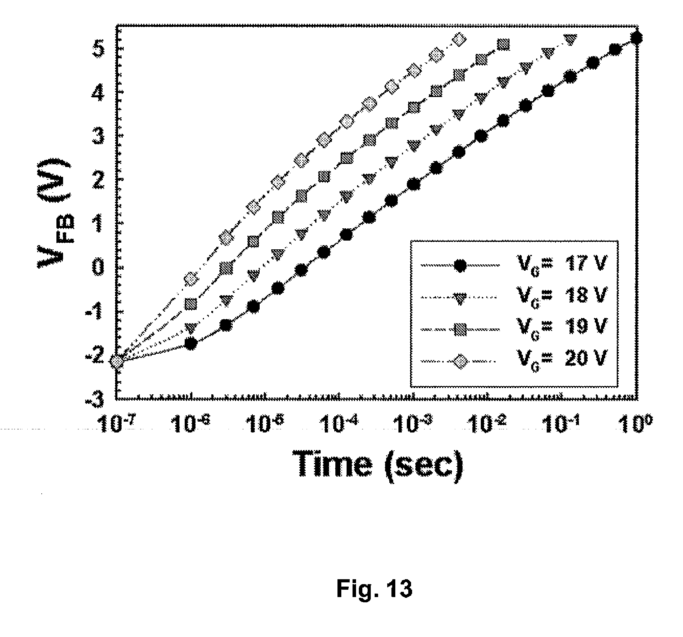

Figure 13 is a plot showing program characteristics with program biases from 17 to 20 V for the MA-BE-SONOS sample. As can be seen, the program time is quite fast at relatively low bias voltages. Furthermore, a threshold shift of over 7 V can be achieved in program times on the order of 1 ms or less. When considered with the data shown in Figure 9, it can be seen that the memory cell according to the present invention can be operated with memory windows of 7 V with high speed, and high density. With such a large memory window, the device is readily adaptable to multiple bit per cell implementations.

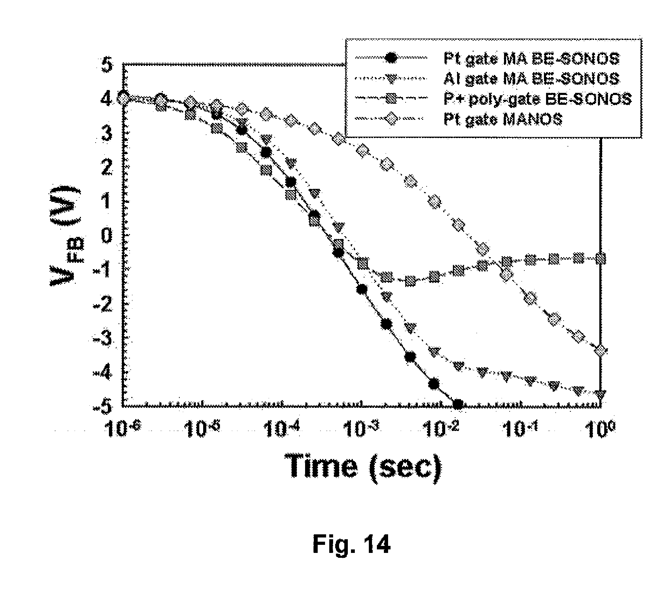

Figure 14 is a graph of flat band voltage versus time with a gate potential at - 20 V for four the separate devices, including a MANOS device having a platinum gate as described above, a BE-SONOS device having a P+ polysilicon gate as described above, a MA BE-SONOS device as described above having an aluminum gate (relatively low work function metal), and a MA BE-SONOS device as described above having a platinum gate (relatively high work function metal). As can be seen, the platinum gate MA BE-SONOS device has a threshold voltage swing of over 8 V in about 10 ms, and does not demonstrate erase saturation. The aluminum gate MA BE-SONOS device also has a very large threshold swing, but begins to show erase saturation at a flat band voltage of about -4 V. The BE-SONOS device having a P+ polysilicon gate as a very high erase speed, but suffers crase saturation at about -1 V after an erase pulse of about 1 ms. The platinum gate MANOS device does not demonstrate erase saturation, but does not reach a flat band voltage of -1 V until after an erase pulse of 50 ms or more.

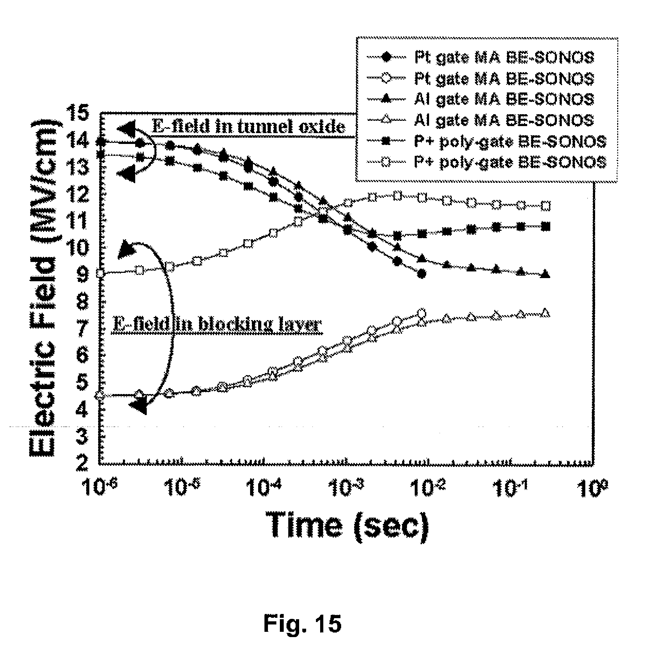

Figure 15 shows transient electric fields for a -20 V gate bias, in the tunnel layers (O1/N1/O2) and blocking layer for a BE-SONOS device having a P+ polysilicon gate as described above, a MA BE-SONOS device as described above having an aluminum gate, and a MA BE-SONOS device as described above having a platinum gate. The draft shows the dramatic difference in the electric field in the blocking layer between the BE-SONOS device having a silicon dioxide blocking layer (starting at about 9 MV/cm) and the MA-BE-SONOS devices with an aluminum oxide blocking layer (starting at about 4.5 MV/cm). The graph also shows that the electric field in the tunneling layer remains below about 14 MV/cm, even with very high speed erase bias conditions.

The examples described above are implemented using n-channel devices, in which the source and drain terminals are doped with n-type impurities. The technology can be implemented using p-channel devices as well, in which the source and drain terminals are doped with p-type impurities.

The examples described above are implemented using devices with flat or planar channel surfaces. The technology can be implemented using non-planar structures, including cylindrical channel surfaces, fin shaped channels, recessed channels and so on.

The examples described above the charge storage stack is implemented so that the tunneling layer is on the channel surface and the blocking dielectric layer is adjacent the gate. In alternatives, the charge storage stack may be reversed, so that the tunneling layer is adjacent the gate terminal and the blocking dielectric is on the channel surface.

While the present invention is disclosed by reference to the preferred embodiments and examples detailed above, it is to be understood that these examples are intended in an illustrative rather than in a limiting sense. It is contemplated that modifications and combinations will readily occur to those skilled in the art, which modifications and combinations will be within the spirit of the invention and the scope of the following claims. What is claimed is:

## Claims

1. A charge trapping memory, comprising:
an array of memory cells, respective memory cells in the array including
a semiconductor body including channel having a channel surface, and source and drain terminals adjacent the channel;
a tunneling dielectric layer on the channel surface, the tunneling dielectric layer a combination of materials having negligible charge trapping efficiency, and arranged to establish a relatively large hole tunneling barrier height in near the channel surface, and an increase in valence band energy level at a first offset from the channel surface and a decrease in valence band energy at a second offset more than 2nm from the channel surface;
a charge trapping dielectric layer on the tunnel dielectric layer;
a blocking dielectric layer on the charge trapping layer, the blocking dielectric layer comprising a material having a dielectric constant κ of 7 or more; and
a gate on the blocking dielectric layer, the gate comprising a metal or metal compound on the blocking dielectric layer.

2. The memory of claim 1,including
circuitry, coupled to the array of memory cells, to apply bias voltages to selected memory cells for read, program and erase operations, including bias voltages across the gate and semiconductor body to induce an electric field of less than 14 MV/cm to cause hole tunneling through the tunneling dielectric layer.

3. The memory of claim 1, wherein the blocking dielectric layer comprises aluminum oxide.

4. The memory of claim 1, wherein the gate comprises platinum.

5. The memory of claim 1, wherein the gate comprises aluminum.

6. The memory of claim 1, wherein the gate comprises tantalum nitride.

7. The memory of claim 1, wherein the tunneling dielectric layer comprises a first silicon oxide layer adjacent the channel and having a thickness less than 20 Å, a low barrier height layer on the first silicon oxide layer, having a hole tunneling barrier height less than 3 eV, and an isolation layer isolating the low barrier height layer from the charge trapping dielectric layer.

8. The memory of claim 7, wherein the thickness of the first silicon oxide layer is 15 Å or less.

9. The memory of claim 1, wherein the tunneling dielectric layer comprises a first silicon oxide layer adjacent the channel and having a thickness of 20 Å or less, a silicon nitride layer on the first silicon oxide layer having a thickness of 30 Å or less, and a silicon oxide layer on the silicon nitride layer having a thickness of 30 Å or less.

10. The memory of claim 1, wherein the tunneling dielectric layer comprises a stack of layers of dielectric material, including a first silicon oxide layer adjacent the channel and having a thickness of 15 Å or less.

11. The memory of claim 1, wherein the tunneling dielectric layer comprises a stack of layers of dielectric material, including a first silicon oxide layer adjacent the channel, and a silicon nitride layer on the first silicon oxide layer having a thickness of 25 Å or less.

12. The memory of claim 1, wherein the tunneling dielectric layer comprises a first silicon oxide layer adjacent the channel and having a thickness of 15 Å or less, a silicon nitride layer on the first silicon oxide layer having a thickness of 25 Å or less, and a silicon oxide layer on the silicon nitride layer having a thickness of 30 Å or less;
the charge trapping dielectric layer comprises silicon nitride having a thickness of 50 Å or more; and
the blocking dielectric layer comprises aluminum oxide having a thickness of 150 Å or more.

13. The memory of claim 1, wherein said bias voltage for inducing hole tunneling is less than 16 Volts, and the hole tunneling current is sufficient to cause reduction in threshold voltage in a selected cell of more than 4 Volts in less than 10 milliseconds.

14. The memory of claim 1, wherein said bias voltage for inducing hole tunneling is less than 20 Volts, and the hole tunneling current is sufficient to cause reduction in threshold voltage in a selected cell of more than 4 Volts in less than 5 milliseconds.

15. The memory of claim 1, wherein the effective oxide thickness EOT of the blocking dielectric layer, the charge trapping dielectric layer and the tunneling dielectric layer is less than 200 Å.

16. A charge trapping memory, comprising:
an array of memory cells, respective memory cells in the array including
a semiconductor body including channel having a channel surface, and source and drain terminals adjacent the channel;
a tunneling dielectric layer on the channel surface, the tunneling dielectric layer a combination of materials having negligible charge trapping efficiency, and arranged to establish a relatively large hole tunneling barrier height in near the channel surface, and an increase in valence band energy level at a first offset from the channel surface and a decrease in valence band energy at a second offset more than 2nm from the channel surface;
a charge trapping dielectric layer on the tunnel dielectric layer;
a blocking dielectric layer on the charge trapping layer, the blocking dielectric layer comprising aluminum oxide;
a gate on the blocking dielectric layer, the gate comprising aluminum.

17. The memory of claim 16, including circuitry, coupled to the array of memory cells, to apply bias voltages to selected memory cells for read, program and erase operations, including bias voltages across the gate and semiconductor body to induce hole tunneling through the tunneling dielectric layer.

18. The memory of claim 16, wherein the tunneling dielectric layer comprises a first silicon oxide layer adjacent the channel and having a thickness of 15 Å or less, a silicon nitride layer on the first silicon oxide layer having a thickness of 25 Å or less, and a silicon oxide layer on the silicon nitride layer having a thickness of 30 Å or less.

19. The memory of claim 16, wherein the tunneling dielectric layer comprises a stack of layers of dielectric material, including a first silicon oxide layer adjacent the channel and having a thickness of 15 Å or less.

20. The memory of claim 16, wherein the tunneling dielectric layer comprises a stack of layers of dielectric material, including a first silicon oxide layer adjacent the channel, and a silicon nitride layer on the first silicon oxide layer having a thickness of 25 Å or less.

21. A charge trapping memory, comprising:
an array of memory cells, respective memory cells in the array including
a semiconductor body including channel having a channel surface, and source and drain terminals adjacent the channel;
a tunneling dielectric layer on the channel surface, the tunneling dielectric layer a combination of materials having negligible charge trapping efficiency, and arranged to establish a relatively large hole tunneling barrier height in near the channel surface, and an increase in valence band energy level at a first offset from the channel surface and a decrease in valence band energy at a second offset more than 2nm from the channel surface;
a charge trapping dielectric layer on the tunnel dielectric layer;
a blocking dielectric layer on the charge trapping layer, the blocking dielectric layer comprising aluminum oxide;
a gate on the blocking dielectric layer, the gate comprising platinum;
circuitry, coupled to the array of memory cells, to apply bias voltages to selected memory cells for read, program and erase operations, including bias voltages across the gate and semiconductor body to induce hole tunneling through the tunneling dielectric layer.

22. The memory of claim 21, wherein the tunneling dielectric layer comprises a first silicon oxide layer adjacent the channel and having a thickness of 15 Å or less, a silicon nitride layer on the first silicon oxide layer having a thickness of 25 Å or less, and a silicon oxide layer on the silicon nitride layer having a thickness of 30 Å or less.

23. The memory of claim 21, wherein the tunneling dielectric layer comprises a stack of layers of dielectric material, including a first silicon oxide layer adjacent the channel and having a thickness of 15 Å or less.

24. The memory of claim 21, wherein the tunneling dielectric layer comprises a stack of layers of dielectric material, including a first silicon oxide layer adjacent the channel, and a silicon nitride layer on the first silicon oxide layer having a thickness of 25 Å or less.
